# FASCICULE DE BREVET EUROPEEN

(11) **EP 2 998 998 B1**
(45) Date de publication et mention de la délivrance du brevet: **22.01.2020**
(21) Numéro de dépôt: 15184980.9
(22) Date de dépôt: 14.09.2015
(51) Int. Cl.: H01L 29/66, H01L 29/78

(54) **PROCÉDÉ DE GRAVURE EN SURFACE D'UNE STRUCTURE TRIDIMENSIONNELLE**
ÄTZUNGSVERFAHREN AN DER OBERFLÄCHE EINER 3D-STRUKTUR
METHOD FOR ETCHING THE SURFACE OF A THREE-DIMENSIONAL STRUCTURE

(30) Priorité: 17.09.2014 FR 1458758
(43) Date de publication de la demande: 23.03.2016
(73) Titulaire: COMMISSARIAT À L'ÉNERGIE ATOMIQUE ET AUX ÉNERGIES ALTERNATIVES, 75015 Paris (FR)
(72) Inventeur: POSSEME, Nicolas, 38000 Grenoble (FR); ARVET, Christian, 38190 Bernin (FR); BARNOLA, Sébastien, 38190 Villard-Bonnot (FR)
(74) Mandataire: Decobert, Jean-Pascal

(56) Documents cités:
- US-A1- 2011 021 027
- US-A1- 2014 080 276
- US-A1- 2014 239 420
- US-B1- 7 476 578

## Description

La présente invention concerne en général la gravure de structures microélectroniques, notamment tridimensionnelles (3D), et plus particulièrement la réalisation d'espaceurs de grille de transistors de type dit FinFET, c'est-à-dire de transistors à effet de champ (FET) dont le canal de conduction comprend une mince lamelle verticale d'un matériau semi-conducteur, qualifiée du terme anglais de « Fin » ou « nageoire ».

### ÉTAT DE LA TECHNIQUE

La course incessante à la réduction des dimensions qui caractérise toute l'industrie de la microélectronique n'a pu se faire qu'avec l'apport d'innovations clés tout au long de décennies de développement depuis que les premiers circuits intégrés ont été produits industriellement dans les années soixante. Alors que les premiers circuits intégrés ne comprenaient qu'une centaine de transistors, les plus récents peuvent en effet en intégrer jusqu'à plusieurs milliards pour les plus élaborés d'entre eux et notamment les processeurs utilisés par toutes sortes de dispositifs informatiques : serveurs, ordinateurs, tablettes, téléphones intelligents ou Smartphones, etc.

Parmi les techniques qui ont été développées par l'industrie de la microélectronique pour accompagner cette croissance qui continue de suivre la loi dite de MOORE, c'est-à-dire un doublement de l'intégration observé tous les deux ans, la mise au point et l'utilisation industrielle depuis les années 70 d'une gravure dite sèche à partir d'un plasma gazeux formé dans un environnement confiné, une chambre de gravure, a contribué significativement à cette évolution. D'abord essentiellement utilisée pour l'enlèvement des couches de résines photosensibles non développées à l'issue des étapes de lithographie, la gravure plasma à progressivement été introduite ensuite pour la gravure des couches fonctionnelles elles-mêmes.

C'est ce type de gravure qui a permis d'accompagner avec succès toutes les évolutions des transistors à effet de champ (FET) de structure métal-oxyde-semi-conducteur (MOS), utilisés par la quasi-totalité des circuits intégrés, vers la technique actuelle la plus couramment employée qui consiste à fabriquer les circuits intégrés en partant de substrats élaborés de type silicium sur isolant, désignés par leur acronyme SOI, de l'anglais « silicon on insulator ». Le substrat élaboré SOI est caractérisé par la présence d'une fine couche superficielle semi-conductrice, le plus souvent du silicium monocristallin, reposant sur une couche continue d'oxyde, dit oxyde enterré ou encore BOX, acronyme de l'anglais « buried oxide layer ». La solidité et la rigidité mécanique de l'ensemble sont assurées par une couche épaisse sous-jacente qui constitue le corps du substrat SOI, souvent qualifié du vocable anglais de « bulk » pour indiquer que le substrat de départ est très généralement fait de silicium massif.

Cette structure plane offre de nombreux avantages pour y réaliser ensuite des transistors MOSFET performants. On retiendra notamment que la couche superficielle de semi-conducteur peut être contrôlée précisément en épaisseur et en dopage. Il est alors très avantageux pour les performances des transistors MOSFET que leur canal, qui est réalisé dans cette mince couche, puisse être complètement déserté de porteurs, c'est-à-dire « fully depleted », vocable anglais, dont l'abrégé est FD, qui est généralement utilisé pour désigner cet état. Ce type de transistors qui est fabriqué à partir de substrats SOI est ainsi désigné par l'acronyme FDSOI. C'est la gravure plasma qui rend possible l'obtention d'une telle structure. Elle est notamment indispensable pour réaliser, sans mettre en œuvre d'opération de lithographie, des éléments devenus indispensables que sont les espaceurs situés de part et d'autre de la grille de commande. Ils permettent notamment de définir par auto-alignement sur la grille les deux autres électrodes d'un transistor MOSFET, c'est-à-dire la source et le drain. Pour ce faire on utilise une caractéristique unique de la gravure plasma qui est qu'elle peut être paramétrée pour être fortement anisotrope permettant ainsi de laisser en place les espaceurs sur les flancs des motifs de grille tout en gravant simultanément toutes les surfaces parallèles au plan du substrat.

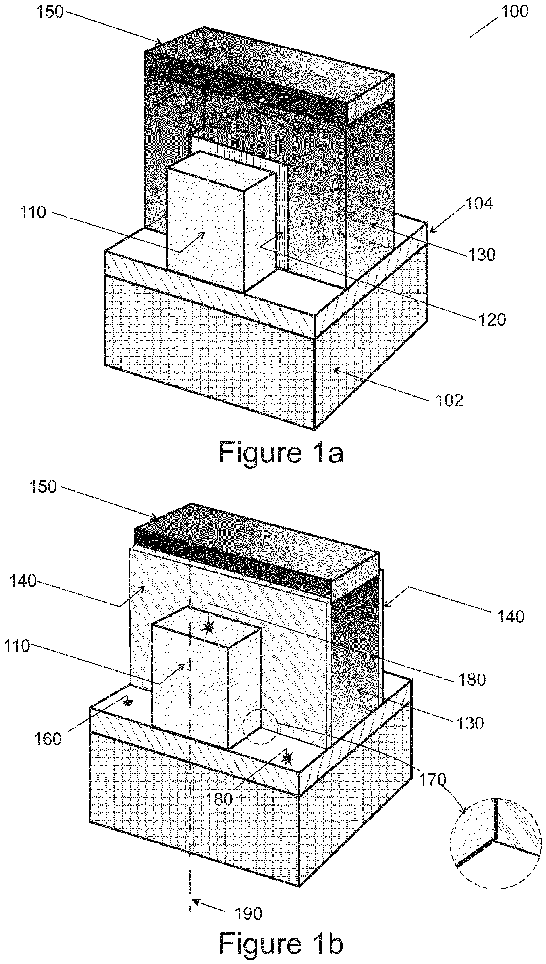

Si la technologie très brièvement décrite ci-dessus a pu être utilisée avec succès jusqu'au nœud technologique de 22 nm (nanomètre = 10⁻⁹ mètre) qui est actuellement en production pour les fabrications les plus avancées, le problème se pose de pouvoir réaliser à une échelle industrielle les futurs nœuds technologiques, dont le suivant doit être, pour suivre la loi de MOORE, un nœud de 15 nm. Pour les nœuds technologiques au-delà de celui de 22 nm l'industrie de la microélectronique doit faire face à de nombreux défis et s'oriente vers l'utilisation de structures 3D pour la réalisation des transistors, la structure plane actuelle, celle dite FDSOI décrite ci-dessus, ne permettant plus d'atteindre les performances souhaitées. C'est en particulier un transistor dit FinFET qui est considéré. Comme montré sur la figure 1a, dans cette structure tridimensionnelle 100, le canal 110 de conduction est alors constitué d'une mince lamelle verticale (suivant la direction 190) de matériau semi-conducteur, typiquement du silicium ou du germanium, qualifiée du terme anglais de « fin » c'est-à-dire de « nageoire » d'où le nom. Il est entouré sur trois côtés par la grille de commande 130 typiquement faite, comme actuellement, de silicium polycristallin et comprenant aussi une couche diélectrique à haute permittivité 120 dite « high-k ». Cela permet d'obtenir des transistors ayant de meilleures performances électriques et aussi de réduire les courants de fuite. La structure ci-dessus pourra aussi comme précédemment avoir été réalisée à partir d'un substrat SOI dont on retrouve la couche BOX 104 et le corps du substrat 102. Une couche de surface au- dessus de cet empilement, et par exemple en un matériau semi-conducteur tel du silicium nanocristallin, est apparente au niveau de la face du substrat (cette couche, généralement très fine, n'est pas visible sur les figures). On notera aussi la présence d'un masque dur 150 au sommet de la grille qui a servi pour la formation de la grille et qui apparaît sur la figure 1b.

La structure FinFET 100 demande toujours cependant que l'on sache réaliser comme précédemment des espaceurs 140 de part et d'autre de la grille 130. Comme illustré sur la figure 1b, après qu'un dépôt ait été effectué, sur toute la surface des dispositifs, d'une couche uniforme d'un matériau diélectrique constituant les espaceurs, on doit pouvoir obtenir par gravure que seuls des espaceurs 140 perpendiculaires au plan du substrat restent en place de part et d'autre de la grille comme représenté. Toutes les autres surfaces, en particulier celles couvrant la lamelle verticale ou « fin » 110, qu'elles soient perpendiculaires ou parallèles au plan du substrat, doivent être gravées complètement. Ceci doit être effectué sans laisser de résidus 160 et sans endommager 180 les surfaces gravées. Par ailleurs il est important d'obtenir une gravure parfaitement anisotrope dans les angles sans formation de pieds 170.

Si la gravure plasma a su s'adapter et a permis de suivre les réductions de taille des motifs à chaque introduction d'un nouveau nœud technologique dans les années passées, sa mise en œuvre pose cependant de plus en plus de problèmes quand la taille diminue, en particulier à partir et au-delà du nœud technologique de 22 nm. Le caractère tridimensionnel (3D) de la structure FinFET fait que les problèmes déjà rencontrés avec une structure plane FDSOI se posent avec encore plus d'acuité. De plus, des problèmes spécifiques apparaissent. En particulier, comme on vient de le voir ci-dessus avec la figure 1b, la réalisation des espaceurs se heurte à une difficulté majeure qui est que le caractère directionnel, très anisotrope, de la gravure plasma ne suffit plus quand il s'agit de graver les espaceurs d'une structure 3D telle que celle d'un FinFET. En effet, au cours d'une même gravure, il faudrait d'une part pouvoir préserver les parties perpendiculaires au plan du substrat situés de part et d'autre de la grille qui vont constituer les espaceurs 140 et, d'autre part, simultanément, pouvoir graver les parties perpendiculaire au plan du substrat au plan situés de part et d'autre du « fin ». Ces exigences sont clairement incompatibles.

On connait par ailleurs du document US-A1-2014/0080276 un procédé de fabrication de transistors FinFET dans lequel on opère une gravure sélective permise par formation, via implantation, d'une couche résistante à la gravure. L'implantation réalisée couvre toutes les surfaces verticales du transistor, et permet une sélectivité lors d'une étape de gravure ultérieure. Cependant, la gravure sélective ainsi proposée n'est pas optimale sur les surfaces diélectriques hors des espaceurs.

C'est donc un objet de l'invention que de décrire un procédé de gravure qui s'affranchisse au moins en partie des problèmes exposés ci-dessus et qui permet dans un cas particulier de pouvoir réaliser les espaceurs de grille de transistors de type FinFET.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Suivant un aspect de l'invention, est décrit un procédé de gravure d'une couche diélectrique en surface d'une structure tridimensionnelle formée sur une face d'un substrat orientée suivant un plan de substrat, ladite structure comprenant des surfaces perpendiculaires au plan de la face du substrat et des surfaces parallèles au plan de substrat, les surfaces perpendiculaires comprenant des premières surfaces perpendiculaires planes dirigées suivant une première orientation et des deuxièmes surfaces perpendiculaires planes dirigées suivant une deuxième orientation différente de la première orientation.

De manière avantageuse, ce procédé comprend successivement les étapes suivantes :
- formation d'une couche superficielle recouvrant les surfaces parallèles et les premières surfaces perpendiculaires par implantation ionique d'au moins une espèce d'ions dans une partie seulement de l'épaisseur de la couche diélectrique, ladite implantation étant configurée pour que la couche superficielle ne couvre pas les deuxièmes surfaces perpendiculaires ;
- enlèvement partiel de la couche superficielle configuré pour enlever totalement la couche superficielle au niveau des surfaces parallèles tout en préservant une partie résiduelle de la couche superficielle au niveau des premières surfaces perpendiculaires ;
- gravure sélective de la couche diélectrique vis-à-vis du matériau de la partie résiduelle de la couche superficielle et vis-à-vis du matériau de la face du substrat.

Ainsi, l'invention permet de graver une couche à la surface d'un substrat comprenant une structure qui peut être géométriquement complexe, cette gravure étant grandement sélective de sorte à enlever la couche diélectrique à certains endroits et à la préserver à d'autres endroits de manière efficace, sans endommager les couches sous-jacentes.

Relativement à l'art antérieur connu, un effet est une meilleure maitrise de la gravure sélective de la couche diélectrique. En effet, la surface de l'espaceur reste seule couverte par la couche superficielle avant cette gravure, les autres surfaces présentant avantageusement le matériau diélectrique en exposition à la gravure. De cette façon deux matériaux seulement sont en jeu durant la gravure si bien que la sélectivité peut être ajustée de manière plus efficace que, notamment, quand trois matériaux ou plus sont en jeu. En autres aspects, le fait que l'implantation ne soit que partielle dans l'épaisseur de la couche diélectrique permet, d'obtenir ce résultat.

Il est fait référence aussi à un dispositif microélectronique obtenu par le procédé de l'invention.

Il s'agit d'un dispositif microélectronique comprenant un substrat et, sur une face du substrat, un transistor de type FinFET comprenant :
- une grille située au-dessus d'une couche de surface de la face du substrat, la couche de surface étant en un matériau semi-conducteur, la grille comportant deux flancs parallèles entre eux et perpendiculaires à un plan de substrat,
- un canal avec deux ailerons chacun situé sur un flanc différent de la grille,
- sur chaque flanc, autour de l'aileron, un espaceur formé avec une couche diélectrique,
caractérisé en ce que les espaceurs comporte une couche superficielle, au-dessus de la couche diélectrique, la couche superficielle étant une couche du matériau de la couche diélectrique dans laquelle sont implantés des ions d'au moins une espèce d'ions.

L'oxygène peut être choisi comme l'une ou la seule espèce d'ions implanté.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1a et 1b illustrent une structure 3D de transistor de type FinFET et montre notamment les espaceurs de grille qu'il faut pouvoir former.
Les figures 2a à 2c illustrent des étapes du procédé de gravure de l'invention qui permettent la formation des espaceurs conformes à la figure 1b.
La figure 3 est une vue en coupe d'un transistor FinFET réalisé avec le procédé de l'invention.

Les dessins joints sont donnés à titre d'exemples et ne sont pas limitatifs de l'invention. Ces dessins sont des représentations schématiques et ne sont pas nécessairement à l'échelle de l'application pratique. En particulier, les épaisseurs relatives des couches et des substrats ne sont pas forcément représentatives de la réalité.

### DESCRIPTION DÉTAILLÉE DE L'INVENTION

Avant d'entrer dans le détail de mode de réalisation de l'invention, notamment en référence aux dessins, des caractéristiques non limitatives que l'invention peut présenter individuellement ou selon toutes combinaisons sont introduites brièvement ci-après :
- l'implantation est configurée pour oxyder le matériau de la couche diélectrique ;
- on utilise au moins du dioxygène comme espèce d'ions à implanter ;
- l'enlèvement partiel de la couche superficielle est une gravure opérée à partir d'un plasma ;
- la gravure de l'enlèvement partiel de la couche superficielle est une gravure anisotrope configurée pour attaquer la couche superficielle au niveau des surfaces parallèles tout en n'attaquant pas ou en attaquant moins la couche superficielle au niveau des premières surfaces perpendiculaires ;
- la gravure anisotrope est réalisée avec un plasma d'argon ou de tétrafluorure de carbone ;
- la gravure sélective est opérée à partir d'un plasma ;
- on opère la gravure anisotrope puis la gravure sélective dans un même réacteur ;
- la gravure sélective est opérée par voie humide ;
- la couche diélectrique (231) est faite par une couche de nitrure, de préférence de nitrure de silicium ;
- la couche diélectrique (231) est faite en un matériau low-k de constante diélectrique plus faible que celle du nitrure de silicium ;
- la couche diélectrique est déposée de manière conforme sur la face du substrat et la structure ;
- l'implantation est configurée pour former une couche superficielle ayant une épaisseur inférieure à la moitié de l'épaisseur de la couche diélectrique déposée ;
- l'implantation est configurée pour former une couche superficielle ayant une épaisseur comprise entre 2 et 3 nm ;
- les parties résiduelles sont employées comme espaceurs au niveau de flancs d'une grille de transistor de type FinFET ;
- la face du substrat comprend une couche de surface en un matériau semi-conducteur ;
- la première orientation et la deuxième orientation sont perpendiculaires.

Il est précisé que dans le cadre de la présente invention, le terme « sur », « surmonte » ou « sous-jacent » ou leurs équivalent ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

Dans la description qui suit, les épaisseurs sont généralement mesurées selon des directions perpendiculaires au plan de la face inférieure de la couche à graver ou d'un substrat sur lequel la couche inférieure est disposée. Ainsi, les épaisseurs sont généralement prises selon une direction verticale sur les figures représentées. En revanche l'épaisseur d'une couche recouvrant un flanc d'un motif est prise selon une direction perpendiculaire à ce flanc.

Dans ce qui suit, on entend par gravure sélective l'enlèvement par gravure d'un matériau donné en préservant au moins en partie, par la sélectivité du procédé employé, d'autres matériaux.

Les termes « couche superficielle » correspondent à une couche qui est formée, en particulier par modification de la couche sous-jacente, en surface du dispositif électronique après la formation de la couche sous-jacente. Elle est ensuite partiellement retirée pour exposer en partie la couche-sous-jacente. L'adjectif « superficielle » ne signifie pas obligatoirement que la couche superficielle résiduelle reste toujours en surface du dispositif lorsque la fabrication de ce dernier est finalisée. Elle peut être par exemple enlevée ou recouverte.

On entend par « conforme » une géométrie de couche qui présente une même épaisseur, aux tolérances de fabrication près, une épaisseur identique malgré les changements de direction de couche, par exemple au niveau de flancs de motif de grille.

Le mot « diélectrique » correspond à un matériau dont la conductivité électrique est suffisamment faible dans l'application donnée pour servir d'isolant.

La présente invention est particulièrement bien adaptée à des gravures sélectives de dispositifs microélectroniques (ce qui inclut les nanotechnologies) qui comprennent des surfaces en relief complexes ici appelées 3D. Notamment, l'invention est utilisable pour des dispositifs présentant un substrat dont une face au moins est orientée suivant un plan et comportant, en relief (et avantageusement en saillie) sur la face du substrat, un ou des motifs dotés de surfaces planes s'étendant, pour certaines d'entre-elles, suivant un premier plan de préférence perpendiculaire à la face du substrat, pour d'autres d'entre-elles, suivant un deuxième plan de préférence perpendiculaire au premier plan et à la face du substrat. Le motif comporte en outre de préférence des surfaces planes parallèles à la face du substrat et en surplomb des autres surfaces du motif. C'est cette configuration que l'on trouve typiquement dans des transistors FinFET au niveau de la grille et du canal de conduction. Les adjectifs « plane », « perpendiculaire » et « parallèle » s'entendent ici aux tolérances de fabrication près.

La description qui suit illustre l'invention dans une application à des fabrications d'espaceurs de grille de transistors FinFET. Elle peut être transposée à d'autres applications pour lesquelles les géométries de structures 3D sont similaires.

Dans l'application à des transistors FinFET, les surfaces parallèles 246 comprennent, outre la surface de la face du substrat, le sommet de la structure 3D, sur la face supérieure des ailerons et sur la face supérieure de la grille 130. Cela correspond au plan xy en figure 26. Les surfaces perpendiculaires comprennent les côtés 242 des ailerons (correspondant aux deuxièmes surfaces perpendiculaires suivant le plan yz) et les zones de flancs 244 de la grille 130 (correspondant aux premières surfaces perpendiculaires suivant le plan xz).

A titre non limitatif, la structure générale de transistors FinFET décrite en référence aux figures 1a et 1b pourra être employée dans la présente invention.

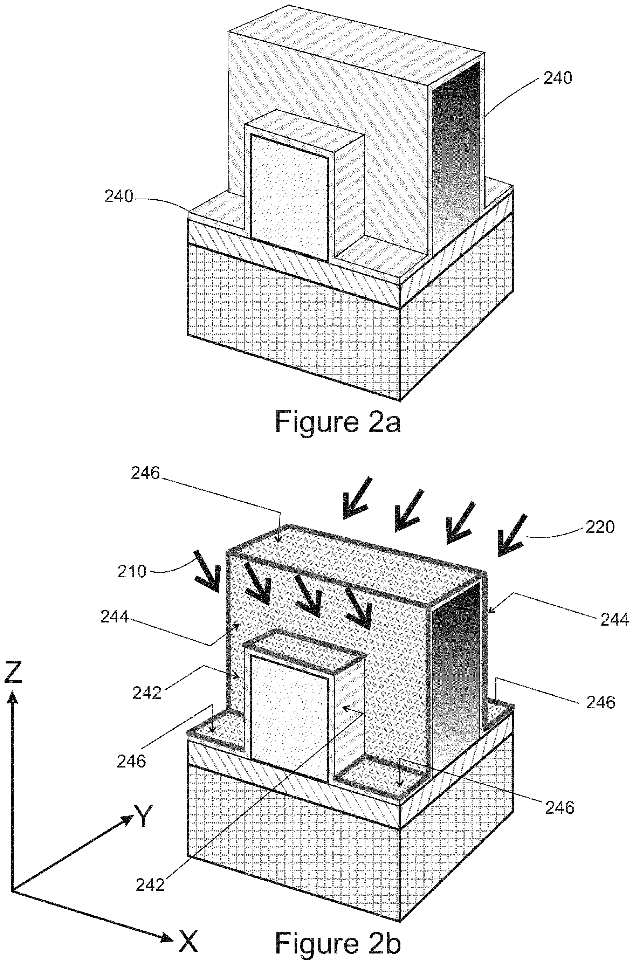

Les illustrations composées des figures 2a à 2c illustrent des étapes du procédé de l'invention.

Comme montré sur la figure 2a qui est une vue en coupe au niveau d'un aileron de canal, la première étape pour la formation des espaceurs de grille consiste à procéder, par exemple d'une façon conventionnelle, à un dépôt avantageusement conforme et aussi de préférence « pleine plaque », c'est-à-dire sur l'ensemble des dispositifs présents à la surface de la face du substrat, du matériau diélectrique composant ces espaceurs. Il s'agit le plus généralement de nitrure de silicium (SiN). À l'issue de cette étape, une couche diélectrique 240, par exemple de nitrure de silicium, d'épaisseur sensiblement identique selon toutes les orientations des surfaces sur lesquelles elle se fait, recouvre l'ensemble des dispositifs en cours de fabrication. La couche déposée est typiquement d'une épaisseur allant de 5 nm à 30 nm.

Comme on l'a vu dans l'état de la technique ce dépôt se fait après formation des grilles des transistors FinFET dont la structure 100 peut être à ce stade celle représentée sur la figure 1a.

Dans une telle structure les dimensions du « Fin » 110 sont typiquement, en largeur, de 5 à 20 nm, et en hauteur, de 20 à 70 nm.

La figure 2b illustre le résultat d'une étape suivante où l'on vient modifier superficiellement la couche diélectrique 240 sur une partie des surfaces en fonction de leur orientation. On crée ainsi une couche superficielle à certains endroits. La modification se fait avantageusement en utilisant une implantation ionique classique, de préférence avec (exclusivement ou non) des ions d'oxygène (O2). Ce procédé permet en effet une sélectivité spatiale d'implantation. La couche superficielle est configurée pour ne pas modifier la totalité de l'épaisseur de la couche diélectrique 240.

À cette fin, dans l'équipement d'implantation, le support du substrat contenant le dispositif (ou plusieurs) en cours de fabrication est incliné pour exposer les surfaces à modifier en fonction de leur orientation spatiale.

Dans le cas des figures, au moins deux implantations, 210 et 220, avec des inclinaisons de préférence symétriques sont mises en œuvre, au cours desquelles on va exposer toutes les surfaces parallèles au plan du substrat 246 et une partie des surfaces perpendiculaires au plan du substrat, c'est-à-dire celles qui sont orientées face au flux directionnel d'ions générés dans l'implanteur et notamment les surfaces 244 qui vont constituer à terme les espaceurs. Les surfaces perpendiculaires au plan du substrat qui sont situées de part et d'autre du « Fin » 242, et qui ne sont donc pas exposées au flux d'ions, ne sont pas modifiées. La direction moyenne du flux d'ions est avantageusement dans un plan parallèle à l'orientation des deuxièmes surfaces perpendiculaires, à savoir les surfaces 242 dans le cas des figures.

L'apport d'oxygène provenant de l'implantation sélective de certaines des surfaces provoque leur oxydation. Une partie de la couche diélectrique ici en nitrure de silicium qui a été déposée à l'étape précédente est convertie en une couche superficielle oxyde de silicium (SiO2). En outre, les défauts induits dans le nitrure par l'étape d'implantation favorisent aussi éventuellement son oxydation à l'air ambiant par exemple, si bien que la surface oxydée est alors du type SiOxNy.

Les conditions d'implantation sont par exemple les suivantes :
Dose d'ions oxygène : dans une gamme allant de 10¹³ à 10¹⁶ atomes par centimètre carré (cm²).
Angle d'inclinaison du substrat : de 20 à 80 degrés en fonction de la géométrie des structures 3D.
Énergie des ions : dans une gamme allant de 0,2 keV (kilo électron-volt) à 2 keV. L'énergie à communiquer aux ions dépend de la profondeur de la couche de nitrure de silicium que l'on désire modifier. Par exemple pour modifier la couche de nitrure sur une profondeur de 2 à 3 nm il faut communiquer aux ions une énergie de 0,5 keV en utilisant une dose de 5x10⁵ atomes/ cm².

L'implantation réalisée est ici directionnelle, notamment par la technique d'accélération de particules par électrostatisme. L'immersion plasma, parfois employée pour implanter des ions est exclue.

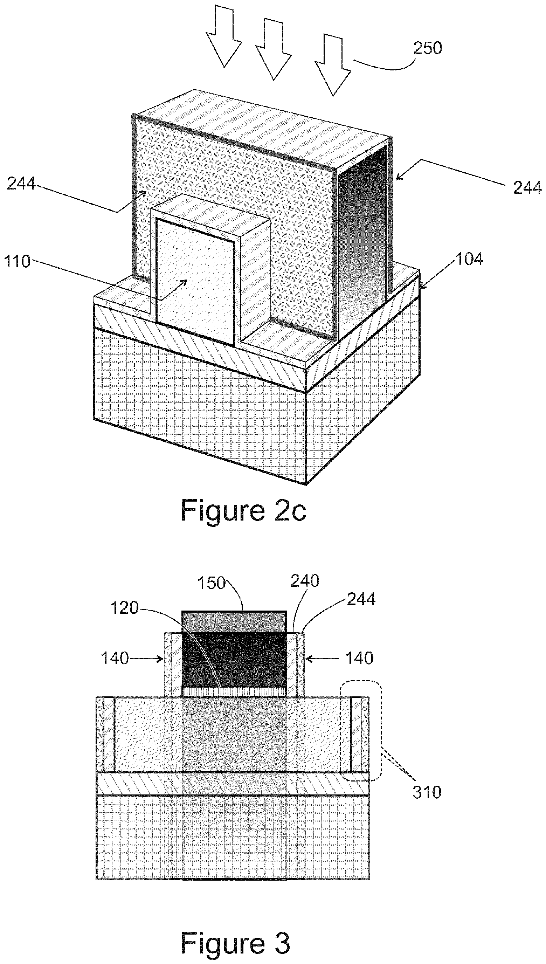

La figure 2c illustre le résultat de l'étape suivante où l'on procède à l'enlèvement de la couche superficielle d'oxyde qui vient d'être formée sur toutes les surfaces parallèles au plan du substrat. Cette opération est effectuée en ayant recours à une gravure anisotrope 250, perpendiculaire au plan du substrat, qui est pratiquée par exemple dans un plasma de préférence d'argon (Ar) ou de tétrafluorure de carbone (CF4) et qui grave donc essentiellement toutes les surfaces oxydées parallèles au plan du substrat. Par exemple, une énergie des ions comprise entre 8 et 13 eV et de préférence 10 eV peut convenir pour cette gravure. À l'issue de cette opération seules les surfaces 244 qui doivent former à terme les espaceurs restent donc dotées d'une surface oxydée.

Cette étape produit une ouverture localisée de la couche superficielle si bien que la couche diélectrique 240 sous-jacente est exposée à l'extérieur à certains endroits bien déterminés.

À l'issue de cette étape on va donc pouvoir enlever l'épaisseur restante de matériau diélectrique formant les espaceurs sur toutes les surfaces, perpendiculaires ou parallèles au plan du substrat, qui ne sont pas ou plus protégées par la couche d'oxyde. On va donc notamment pouvoir enlever ce matériau tout autour du « Fin » du transistor FinFET tout en laissant en place les couches 244 situées de part et d'autre de la grille.

Le résultat est alors totalement conforme à ce qui est recherché pour un transistor FinFET et donc comme illustré sur la figure 1b précédemment discutée.

L'enlèvement de la couche restante du matériau formant les espaceurs, en général du nitrure de silicium, se fait préférentiellement à l'aide d'une gravure isotrope qui peut s'effectuer d'au moins deux manières différentes qui sont toutes deux sélectives vis-à-vis de la couche d'oxyde de silicium (SiO2) ou plus généralement de SiOxNy sous-jacente sur laquelle repose la structure 100, c'est-à-dire la couche 104, et aussi vis-à-vis des couches superficielles d'oxyde des surfaces 244 qui sont restées en place.

La gravure des parties de la couche de nitrure de silicium non protégées par de l'oxyde peut se pratiquer à partir d'un plasma formé dans une chambre de gravure de type à couplage inductif (ICP) ou de type à couplage capacitif (CCP). Par exemple, dans un réacteur de type ICP, les conditions de gravure du nitrure de silicium peuvent être les suivantes : pression = 10 à 500 milli Torr ; puissance de la source = de 100 à 2000 Watts; pulsation de la source de polarisation à une fréquence de 200 à 5000 Hz avec un rapport cyclique de 10 à 80%. Cette étape emploie avantageusement un flux de tétrachlorosilane (SiCl4).

Plus précisément, avec les conditions suivantes : pression = 80 milli Torr ; puissance de la source = 400 Watts ; tension de polarisation = 250 Volts ; fréquence de pulsation 500 Hz avec un rapport cyclique de 50% ; débit de fluorométhane (CH3F) = 200 centimètre cube par minute (sccm) ; débit d'oxygène (O2) = 120 sccm ; débit d'hélium (He) = 5 sccm ; débit de SiCl4 = 5 sccm ; température du porte-substrat = 60°C ; on obtient un taux de gravure du nitrure de 10 nm par minute.

La gravure des parties de la couche de nitrure de silicium non protégées par de l'oxyde peut aussi se faire par voie humide, par exemple dans une solution à base d'acide phosphorique (H3PO4), qui peut être chauffée entre 140 et 180°C. Cette gravure du nitrure se fait sans consommation aucune des couches d'oxyde de silicium. On observe par exemple, dans une solution H3PO4 chauffée à 180°C, un taux de gravure de 4 nm/minute d'un film de nitrure de silicium de type Si3N4 laissé dans son état originel après dépôt dans un réacteur de type LPCVD acronyme de l'anglais « low-pressure chemical vapor déposition », c'est-à-dire « dépôt chimique en phase vapeur à basse pression ».

La figure 3 est une vue en coupe de la structure après gravure des parties non protégées de la couche de nitrure comme montré sur la figure 1b. On y retrouve le masque dur 150 mentionné précédemment et la couche diélectrique à haute permittivité 120 qui entoure le « Fin » comme on l'a vu sur la figure 1a. Les espaceurs 140 apparaissent de part et d'autre de la grille qui sont donc composés de deux couches : la couche originelle de nitrure 240 et la couche superficielle oxydée 244 qui a servi de protection lors de la gravure

On remarquera ici qu'un aspect du procédé de l'invention qui, par souci de clarté, n'apparaît pas dans les figures précédentes et n'a pas été mentionné avant, est que l'on forme également des couches d'espaceurs dans la zone 310 à chaque bout du « Fin » comme montré sur la figure 3. Ces couches qui n'ont aucune utilité fonctionnelle ne présentent pas non plus d'inconvénient pour la structure FinFET réalisée avec le procédé de l'invention.

## Revendications

1. Procédé de gravure d'une couche diélectrique (240) située en surface d'une structure tridimensionnelle formée sur une face d'un substrat orientée suivant un plan de substrat, ladite structure comprenant des surfaces perpendiculaires au plan de substrat et des surfaces parallèles au plan de substrat, les surfaces perpendiculaires comprenant des premières surfaces perpendiculaires planes dirigées suivant une première orientation et des deuxièmes surfaces perpendiculaires planes dirigées suivant une deuxième orientation différente de la première orientation,
**caractérisé par le fait qu'**il comprend successivement les étapes suivantes :
- formation d'une couche superficielle recouvrant les surfaces parallèles et les premières surfaces perpendiculaires par implantation ionique d'au moins une espèce d'ions dans une partie seulement de l'épaisseur de la couche diélectrique (240), ladite implantation étant configurée pour que la couche superficielle ne couvre pas les deuxièmes surfaces perpendiculaires;
- enlèvement partiel de la couche superficielle configuré pour enlever totalement la couche superficielle au niveau des surfaces parallèles tout en préservant une partie résiduelle de la couche superficielle au niveau des premières surfaces perpendiculaires;
- gravure sélective de la couche diélectrique (240) vis-à-vis du matériau de la partie résiduelle de la couche superficielle et vis-à-vis du matériau de la face du substrat.

2. Procédé selon la revendication 1, dans lequel l'implantation est configurée pour oxyder le matériau de la couche diélectrique (240).

3. Procédé selon la revendication précédente dans lequel on utilise au moins du dioxygène comme espèce d'ions à implanter.

4. Procédé selon l'une des revendications précédentes dans lequel l'enlèvement partiel de la couche superficielle est une gravure opérée à partir d'un plasma.

5. Procédé selon la revendication 4 dans lequel la gravure de l'enlèvement partiel de la couche superficielle est une gravure anisotrope configurée pour attaquer la couche superficielle au niveau des surfaces parallèles tout en n'attaquant pas ou en attaquant moins la couche superficielle au niveau des premières surfaces perpendiculaires.

6. Procédé selon la revendication 5 dans lequel la gravure anisotrope est réalisée avec un plasma d'argon ou de tétrafluorure de carbone.

7. Procédé selon l'une des revendications précédentes dans lequel la gravure sélective est opérée à partir d'un plasma.

8. Procédé selon la revendication 7 en combinaison avec l'une des revendications 4, 5 ou 6 dans lequel on opère la gravure de l'enlèvement partiel puis la gravure sélective dans un même réacteur.

9. Procédé selon l'une des revendications 1 à 6 dans lequel la gravure sélective est opérée par voie humide.

10. Procédé selon l'une des revendications précédentes dans lequel la couche diélectrique (240) est faite par une couche de nitrure, de préférence de nitrure de silicium.

11. Procédé selon l'une des revendications 1 à 9 dans lequel la couche diélectrique (240) est faite en un matériau low-k de constante diélectrique plus faible que celle du nitrure de silicium.

12. Procédé selon l'une des revendications précédentes dans lequel la couche diélectrique (240) est déposée de manière conforme sur la face du substrat et la structure.

13. Procédé selon la revendication précédente dans lequel l'implantation est configurée pour former une couche superficielle ayant une épaisseur inférieure à la moitié de l'épaisseur de la couche diélectrique (240) déposée.

14. Procédé selon l'une des revendications précédentes dans lequel l'implantation est configurée pour former une couche superficielle ayant une épaisseur comprise entre 2 et 3 nm.

15. Procédé selon l'une des revendications précédentes dans lequel les parties résiduelles sont employées comme espaceurs (140) au niveau de flancs d'une grille (130) de transistor de type FinFET.

16. Procédé selon l'une des revendications précédentes dans lequel la face du substrat comprend une couche de surface en un matériau semi-conducteur.

17. Procédé selon l'une des revendications précédentes dans lequel la première orientation et la deuxième orientation sont perpendiculaires.

## Patentansprüche

1. Verfahren zum Ätzen einer dielektrischen Schicht (240), die sich an der Oberfläche einer dreidimensionalen Struktur befindet, welche auf einer Seite eines Substrats gebildet ist, die gemäß einer Substratebene ausgerichtet ist, wobei die Struktur zur Substratebene senkrechte Flächen und zur Substratebene parallele Flächen umfasst, wobei die senkrechten Flächen erste planare senkrechte Flächen umfassen, die gemäß einer ersten Ausrichtung gerichtet sind, und zweite planare senkrechte Flächen, die gemäß einer zweiten Ausrichtung gerichtet sind, welche sich von der ersten Ausrichtung unterscheidet,
**dadurch gekennzeichnet, dass** es nacheinander die folgenden Schritte umfasst:
- Bilden einer oberflächlichen Schicht, die die parallelen Flächen und die ersten senkrechten Flächen bedeckt, durch Ionenimplantation mindestens einer lonenspezies in nur einem Teil der Dicke der dielektrischen Schicht (240), wobei die Implantation so konfiguriert ist, dass die oberflächliche Schicht die zweiten senkrechten Flächen nicht abdeckt;
- teilweises Entfernen der oberflächlichen Schicht, das dafür konfiguriert ist, die oberflächliche Schicht im Bereich der parallelen Flächen vollständig zu entfernen, während gleichzeitig im Bereich der ersten senkrechten Flächen ein Restteil der oberflächlichen Schicht beibehalten wird;
- selektives Ätzen der dielektrischen Schicht (240) gegenüber dem Material des Restteils der oberflächlichen Schicht und gegenüber dem Material der Seite des Substrats.

2. Verfahren nach Anspruch 1, wobei die Implantation dafür konfiguriert ist, das Material der dielektrischen Schicht (240) zu oxidieren.

3. Verfahren nach dem vorstehenden Anspruch, wobei als zu implantierende lonenspezies mindestens Disauerstoff verwendet wird.

4. Verfahren nach einem der vorstehenden Ansprüche, wobei das teilweise Entfernen der oberflächlichen Schicht ein Ätzen ist, das auf Grundlage eines Plasmas erfolgt.

5. Verfahren nach Anspruch 4, wobei das Ätzen zum teilweisen Entfernen der oberflächlichen Schicht ein anisotropes Ätzen ist, das dafür konfiguriert ist, die oberflächliche Schicht im Bereich der parallelen Flächen anzugreifen, während gleichzeitig die oberflächliche Schicht im Bereich der ersten senkrechten Flächen nicht angegriffen oder weniger angegriffen wird.

6. Verfahren nach Anspruch 5, wobei das anisotrope Ätzen mit einem Argon- oder Kohlenstofftetrafluorid-Plasma ausgeführt wird.

7. Verfahren nach einem der vorstehenden Ansprüche, wobei das selektive Ätzen auf Grundlage eines Plasmas erfolgt.

8. Verfahren nach Anspruch 7 in Kombination mit einem der Ansprüche 4, 5 oder 6, wobei das Ätzen zum teilweisen Entfernen, und anschließend das selektive Ätzen in ein und demselben Reaktor erfolgen.

9. Verfahren nach einem der Ansprüche 1 bis 6, wobei das selektive Ätzen nass erfolgt.

10. Verfahren nach einem der vorstehenden Ansprüche, wobei die dielektrische Schicht (240) aus einer Nitridschicht, vorzugsweise Siliziumnitrid, besteht.

11. Verfahren nach einem der Ansprüche 1 bis 9, wobei die dielektrische Schicht (240) aus einem Low-k-Material mit einer niedrigeren Dielektrizitätskonstante als derjenigen des Siliziumnitrids besteht.

12. Verfahren nach einem der vorstehenden Ansprüche, wobei die dielektrische Schicht (240) auf der Seite des Substrats und der Struktur übereinstimmend abgeschieden wird.

13. Verfahren nach dem vorstehenden Anspruch, wobei die Implantation dafür konfiguriert ist, eine oberflächliche Schicht zu bilden, die eine Dicke aufweist, die kleiner ist als die halbe Dicke der abgeschiedenen dielektrischen Schicht (240).

14. Verfahren nach einem der vorstehenden Ansprüche, wobei die Implantation dafür konfiguriert ist, eine oberflächliche Schicht zu bilden, die eine Dicke im Bereich zwischen 2 und 3 nm aufweist.

15. Verfahren nach einem der vorstehenden Ansprüche, wobei die Restteile als Abstandshalter (140) im Bereich der Flanken eines Gates (130) eines Transistors vom Typ FinFET genutzt werden.

16. Verfahren nach einem der vorstehenden Ansprüche, wobei die Seite des Substrats eine Oberflächenschicht aus einem Halbleitermaterial umfasst.

17. Verfahren nach einem der vorstehenden Ansprüche, wobei die erste Ausrichtung und die zweite Ausrichtung senkrecht sind.

## Claims

1. Method for etching a dielectric layer (240) situated on the surface of a three-dimensional structure formed on a face of a substrate oriented along a substrate plane, said structure comprising surfaces perpendicular to the substrate plane and surfaces parallel to the substrate plane, the perpendicular surfaces comprising first flat perpendicular surfaces directed according to a first orientation and second flat perpendicular surfaces directed according to a second orientation different from the first orientation,
**characterised by** the fact that it comprises successively the following steps:
- forming of a superficial layer covering the parallel surfaces and the first perpendicular surfaces by ionic implantation of at least one ion species in only one portion of the thickness of the dielectric layer (240), said implantation being configured such that the superficial layer does not cover the second perpendicular surfaces;
- partially removing the superficial layer configured to totally remove the superficial layer at the level of the parallel surfaces while preserving a residual portion of the superficial layer at the level of the first perpendicular surfaces;
- selectively etching the dielectric layer (240) with respect to the material of the residual portion of the superficial layer and with respect to the material of the face of the substrate.

2. Method according to claim 1, wherein the implantation is configured to oxidise the material of the dielectric layer (240).

3. Method according to the preceding claim, wherein at least dioxygen is used as an ion species to be implanted.

4. Method according to one of the preceding claims, wherein the partial removal of the superficial layer is an etching carried out from a plasma.

5. Method according to claim 4, wherein the etching of the partial removal of the superficial layer is an anisotropic etching configured to attack the superficial layer at the level of the parallel surfaces while not attacking or while attacking superficial layer less at the level of the first perpendicular surfaces.

6. Method according to claim 5, wherein the anisotropic etching is carried out with an argon or carbon tetrafluoride plasma.

7. Method according to one of the preceding claims, wherein the selective etching is carried out from a plasma.

8. Method according to claim 7 combined with one of claims 4, 5 or 6, wherein the etching of the partial removal then the selective etching in one same reactor are carried out.

9. Method according to one of claims 1 to 6, wherein the selective etching is carried out by the wet method.

10. Method according to one of the preceding claims, wherein the dielectric layer (240) is made by a nitride layer, preferably silicon nitride.

11. Method according to one of claims 1 to 9, wherein the dielectric layer (240) is made of a dielectric constant low-k material weaker than that of silicon nitride.

12. Method according to one of the preceding claims, wherein the dielectric layer (240) is arranged in a conform manner on the face of the substrate and the structure.

13. Method according to the preceding claim, wherein the implantation is configured to form a superficial layer having a thickness less than half of the thickness of the deposited dielectric layer (240).

14. Method according to one of the preceding claims, wherein the implantation is configured to form a superficial layer having a thickness of between 2 and 3nm.

15. Method according to one of the preceding claims, wherein the residual portions are used as spacers (140) at the level of edges of a FinFET-type transistor gate (130).

16. Method according to one of the preceding claims, wherein the face of the substrate comprises a surface layer made of a semi-conductive material.

17. Method according to one of the preceding claims, wherein the first orientation and the second orientation are perpendicular.
